# EUROPEAN PATENT APPLICATION

(11) **EP 4 343 863 A1**
(43) Date of publication of application: **27.03.2024**
(21) Application number: 23177182.5
(22) Date of filing: 05.06.2023
(51) Int. Cl.: H01L 33/00, H01L 33/06, H01L 33/28, H01L 33/32, H01L 25/075

(54) **LIGHT EMITTING ELEMENT, METHOD FOR FABRICATING LIGHT EMITTING ELEMENT, AND DISPLAY DEVICE INCLUDING LIGHT EMITTING ELEMENT**

(30) Priority: 20.09.2022 KR 20220118817
(71) Applicant: Samsung Display Co., Ltd., Yongin-si, Gyeonggi-do 17113 (KR)
(72) Inventor: JEON, Sang Ho, 17113 Yongin-si (KR); CHAE, Ji Song, 17113 Yongin-si (KR)
(74) Representative: Marks & Clerk LLP

(57) **Abstract**

A light emitting element includes an N-type semiconductor layer including a zinc oxide semiconductor, a P-type semiconductor layer, and an active layer disposed between the N-type semiconductor layer and the P-type semiconductor layer. The active layer has a quantum well including a barrier layer and a well layer including zinc oxide.

## Description

### BACKGROUND

### 1. Technical Field

Various embodiments relate to a light emitting element, a method of fabricating the light emitting element, and a display device including the light emitting element.

### 2. Description of Related Art

With the development of information technology, the importance of a display device, which is a connection medium between a user and information, has been increased. The display device may include a light emitting element that emits light. The light emitting element may include a structure in which an active layer is formed between semiconductor layers. Light may be emitted from the active layer by recombination of electrons and holes.

To ensure sufficient efficiency of the light emitting element, it is desirable that the factors of reducing the emission efficiency of the light emitting element are removed. For example, during a process of fabricating light emitting elements, there is need to prevent a crack, a pin-hole, or the like from being formed in layers for forming the light emitting element.

### SUMMARY

Various embodiments are directed to a light emitting element, a method of fabricating the light emitting element, and a display device including the light emitting element, which has improved emission efficiency and is capable of preventing various factors from occurring during a fabrication process.

However, embodiments are not limited to those set forth herein. The above and other embodiments will become more apparent to one of ordinary skill in the art to which the disclosure pertains by referencing the detailed description of the disclosure given below.

In an embodiment a light emitting element includes: an N-type semiconductor layer including a zinc oxide semiconductor; a P-type semiconductor layer; and an active layer disposed between the N-type semiconductor layer and the P-type semiconductor layer. The active layer has a quantum well including a barrier layer and a well layer including zinc oxide.

In one or more embodiments, the zinc oxide semiconductor of the N-type semiconductor layer may include an oxygen vacancy and may not be doped with a dopant.

In one or more embodiments, the P-type semiconductor layer may include GaN having P-type semiconductor characteristics. The well layer may include GaN.

In one or more embodiments, the N-type semiconductor layer and the well layer may include a same material. The P-type semiconductor layer and the barrier layer may include a same material.

In one or more embodiments, the well layer may include indium-free zinc oxide.

In one or more embodiments, the active layer may further include a mixed layer formed by mixing two or more materials with each other.

In one or more embodiments, the mixed layer may include: a first mixed layer adjacent to the N-type semiconductor layer; and a second mixed layer adjacent to the P-type semiconductor layer.

In one or more embodiments, the well layer and the barrier layer may be disposed between the first mixed layer and the second mixed layer. The first mixed layer may contact the N-type semiconductor layer. The second mixed layer may contact the P-type semiconductor layer.

In one or more embodiments, each of the first mixed layer and the second mixed layer may be formed by mixing a material for forming the N-type semiconductor layer and a material for forming the P-type semiconductor layer.

In one or more embodiments, each of the first mixed layer and the second mixed layer may be formed by mixing a material for forming the well layer and a material for forming the barrier layer.

In one or more embodiments, each of the first mixed layer and the second mixed layer may include zinc oxide and GaN.

In an embodiment, a light emitting element includes: an N-type semiconductor layer including ZnO; a P-type semiconductor layer including GaN; and an active layer disposed between the N-type semiconductor layer and the P-type semiconductor layer. The active layer includes a well layer including a material of the N-type semiconductor layer, and a barrier layer including a material of the P-type semiconductor layer.

In an embodiment, a method of fabricating a light emitting element includes: forming an N-type semiconductor layer on a growth substrate; forming an active layer on the N-type semiconductor layer; forming a P-type semiconductor layer on the active layer; and patterning an emission stack including the N-type semiconductor layer, the active layer, and the P-type semiconductor layer. The N-type semiconductor layer includes an oxide semiconductor (e.g., oxide material). The P-type semiconductor layer includes a nitride semiconductor. The active layer has a quantum well including a barrier layer and a well layer including zinc oxide.

In one or more embodiments, the N-type semiconductor layer may be formed before the forming of the P-type semiconductor.

In one or more embodiments, the forming of the N-type semiconductor layer may include forming the N-type semiconductor layer such that a zinc oxide semiconductor layer includes an oxygen vacancy.

In one or more embodiments, the N-type semiconductor layer may include a zinc oxide semiconductor layer including an oxygen vacancy. The well layer may include GaN. The P-type semiconductor layer may include GaN doped with a dopant.

In one or more embodiments, forming the active layer may include: forming a first mixed layer on the N-type semiconductor layer; forming the barrier layer and the well layer on the first mixed layer; and forming a second mixed layer on the barrier layer and the well layer.

In one or more embodiments, the forming of the first mixed layer may include: providing zinc oxide having a composition ratio at which a content of oxygen is lower than a content of zinc; and providing GaN.

In one or more embodiments, the forming of the first mixed layer may include disposing the first mixed layer into contact with the N-type semiconductor layer.

In an embodiment, a display device includes: a base layer; and a pixel disposed on the base layer and including a light emitting element. The light emitting element includes: an N-type semiconductor layer; a P-type semiconductor layer; and an active layer disposed between the N-type semiconductor layer and the P-type semiconductor layer. The active layer has a quantum well including a barrier layer and a well layer including zinc oxide.

At least some of the above and other features of the invention are set out in the claims.

### BRIEF DESCRIPTION OF THE DRAWINGS

FIGS. 1 to 3 are schematic sectional views each illustrating a light emitting element in accordance with an embodiment.
FIG. 4 is a flowchart illustrating a method of fabricating a light emitting element in accordance with an embodiment.
FIG. 5 is a flowchart illustrating the step of forming an active layer in accordance with an embodiment.
FIGS. 6, 7, and 8 are schematic sectional views illustrating, by process steps, a method of fabricating the light emitting element in accordance with an embodiment.
FIG. 9 is a schematic plan view illustrating a display device in accordance with an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for certain materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" may encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Various embodiments relate to a light emitting element, a method of fabricating the light emitting element, and a display device including the light emitting element. Hereinafter, the light emitting element, the method of fabricating the light emitting element, and the display device including the light emitting element in accordance with an embodiment will be described with reference to the attached drawings.

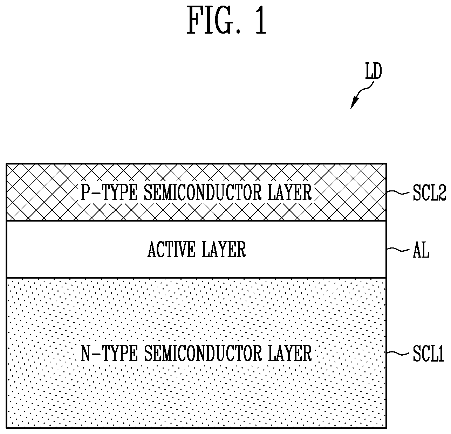

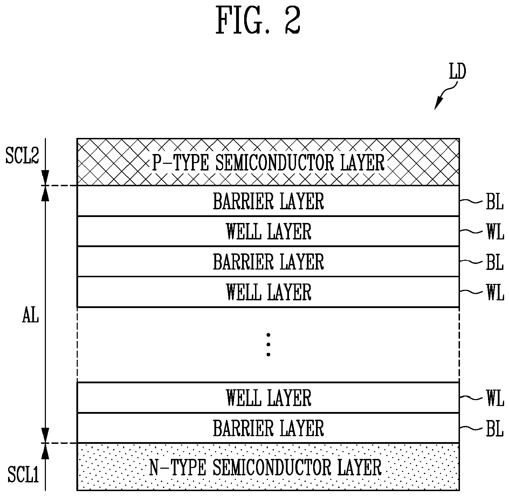

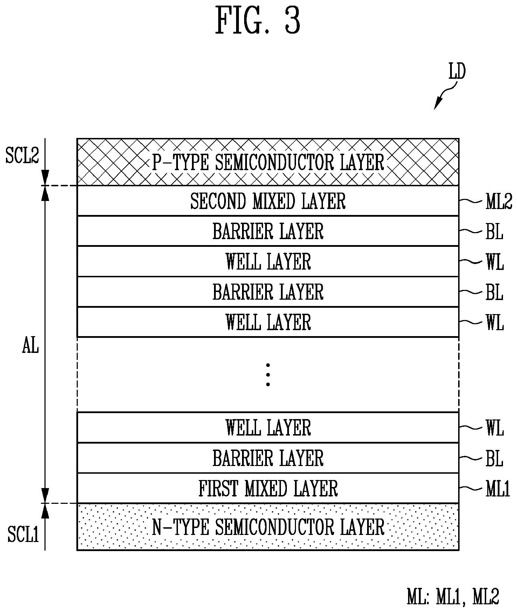

FIGS. 1 and 3 are schematic sectional views each illustrating a light emitting element in accordance with an embodiment. FIG. 1 is a schematic sectional view illustrating a light emitting element LD in accordance with an embodiment. FIG. 2 is a schematic sectional view illustrating a light emitting element LD in accordance with an embodiment. FIG. 3 is a schematic sectional view illustrating a light emitting element LD in accordance with another embodiment.

A light emitting element LD in accordance with an embodiment will be described. The light emitting element LD may emit light. The light emitting element LD may be a light emitting diode including inorganic material. In one or more embodiments, the light emitting element LD may have a size having the nanometer scale to the micrometer scale, but embodiments are not limited thereto.

The light emitting element LD may have various shapes. For example, the light emitting element LD may have a pillar-like shape extending in a direction. Here, the term "pillar-like shape" may include a rod-like shape and a bar-like shape such as a cylindrical shape and a prismatic shape that is longer in a longitudinal direction L and has an aspect ratio greater than 1, and the cross-sectional shape thereof is not limited to a certain shape. However, embodiments are not limited thereto.

The light emitting element LD includes an N-type semiconductor layer SCL1, a P-type semiconductor layer SCL2, and an active layer AL.

The N-type semiconductor layer SCL1 may be disposed on a first surface of the active layer AL. The N-type semiconductor layer SCL1 may include an N-type oxide semiconductor. For example, the N-type semiconductor layer SCL1 may include a zinc oxide (e.g., ZnₓO_{y} or ZnO) semiconductor.

The zinc oxide semiconductor may include oxygen vacancies and have properties of an N-type semiconductor. For example, as the zinc oxide semiconductor may include the oxygen vacancies, the zinc oxide semiconductor may function as N-type semiconductor material even through the zinc oxide semiconductor is not doped with a dopant. However, embodiments are not limited thereto. For instance, the zinc oxide semiconductor may be doped with materials of group III (e.g., Al, Ga, or the like) so that the electron concentration of the N-type semiconductor layer SCL1 may be increased. In one or more embodiments, the N-type semiconductor layer SCL1 may have a carrier concentration of about 10¹⁷/cm³ or more, without being doped with a dopant. However, embodiments are not limited thereto, and the carrier concentration of the N-type semiconductor layer SCL1 may be adjusted by adjusting the concentration of the oxygen vacancies therein. For example, if the concentration of the oxygen vacancies in the N-type semiconductor layer SCL1 is increased, the carrier concentration may be increased. In order to increase the carrier concentration in the N-type semiconductor layer SCL1, zinc oxide with an increased concentration of oxygen vacancies may be manufactured. Zinc oxide with reduced concentration of oxygen vacancies may be manufactured to reduce carrier concentration in the N-type semiconductor layer SCL1. The concentration of oxygen vacancies may be controlled by a variety of known methods, some examples of which will be described below.

The zinc oxide semiconductor may be a II-VI group compound semiconductor of a wide band gap, which has relatively wide energy band-gap (e.g., about 3.37 eV) at a room temperature, and may have relatively large exciton binding energy (e.g., about 60 meV). The zinc oxide semiconductor may have excellent light efficiency as compared to an existing ZnSe-based semiconductor having exciton binding energy of about 21 meV, which is a II-VI group compound, or as compared to a GaN-based semiconductor having exciton binding energy of about 28 meV, which is a III-V group compound. Thus, the light emitting element LD in accordance with an embodiment may have high light efficiency.

The P-type semiconductor layer SCL2 may be disposed on a second surface of the active layer AL. The P-type semiconductor layer SCL2 may include a P-type nitride semiconductor. For example, the P-type nitride semiconductor may include one or more selected from the group consisting of InAlGaN, GaN, AlGaN, InGaN, AlN, and InN, and may include a P-type semiconductor layer doped with a dopant such as Mg, Si, Ge, and Sn. For example, the P-type semiconductor layer SCL2 in accordance with an embodiment may include GaN doped with Mg. However, embodiments are not limited thereto, and the P-type semiconductor layer SCL2 may include various nitride semiconductors.

The active layer AL is disposed between the N-type semiconductor layer SCL1 and the P-type semiconductor layer SCL2. The active layer AL is a layer from which light is emitted by recombination of holes and electrons. In one or more than embodiments, the active layer AL may have a single-quantum well structure (e.g., a single-quantum well) or a multi-quantum well structure (e.g., a multi-quantum well).

For example, referring to FIG. 2, the active layer AL may have a structure formed by alternately stacking barrier layers BL and well layers WL. Each barrier layer BL may form a quantum barrier for forming the quantum well structure. Each well layer WL may form a quantum well for forming the quantum well structure. For example, the barrier layers BL and the well layers WL may be alternately disposed on each other to form a superlattice structure. In one or more embodiments, the barrier layer BL and the well layer WL may include different materials. For example, the barrier layer BL may include GaN, and the well layer WL may include zinc oxide.

In one or more embodiments, the barrier layer BL and the P-type semiconductor layer SCL2 may include a same material. For example, the barrier layer BL may include nitride (e.g., GaN). The P-type semiconductor layer SCL2 may include P-type GaN including a dopant as a nitride semiconductor.

In one or more embodiments, the well layer WL and the N-type semiconductor layer SCL1 may include a same material. For example, the well layer WL may include oxide (e.g., zinc oxide). The N-type semiconductor layer SCL1 may include an oxide semiconductor, e.g., an N-type zinc oxide semiconductor including oxygen vacancies. In the case that the light emitting element LD in accordance with an embodiment is fabricated, the N-type semiconductor layer SCL1 may be formed prior to formation of the active layer AL and the P-type semiconductor layer SCL2. For example, in the case that the well layer WL is formed to form the active layer AL, the N-type semiconductor layer SCL1 may have been already formed. In one or more embodiments, the well layer WL and the N-type semiconductor layer SCL1 may include a same material (e.g., zinc oxide). For example, lattice mismatch between the well layer WL and the N-type semiconductor layer SCL1 may be substantially prevented from occurring. Hence, strain may be prevented from occurring in the active layer AL including the well layer WL.

In one or more embodiments, the well layer WL and the N-type semiconductor layer SCL1 may include zinc oxide, and the barrier layer BL and the P-type semiconductor layer SCL2 may include GaN, so that lattice mismatch may not occur in the case that layers are formed. For example, the well layer WL including zinc oxide and the barrier layer BL including GaN may not only form the active layer AL, but may also function as a strain prevention layer between the N-type semiconductor layer SCL1 and the P-type semiconductor layer SCL2. Therefore, a fabrication defect (e.g., a crack, a pin-hole, or the like) may be prevented from occurring during a process of fabricating the light emitting element LD, and the light efficiency of the light emitting element LD may be enhanced or improved.

Due to lattice mismatch between indium and GaN, which function as dopants, some strain may occur in an element to which indium and GaN are applied. Strain occurring in the element may exert an effect on the efficiency of the element, which are quantum confined Stark effect (QCSE) phenomenon, non-radiative energy transition (e.g., auger recombination), or the like. Hence, the strain may be required to be prevented from occurring in the element.

In one or more embodiments, the well layer WL may include indium-free oxide. In one or more embodiments, the well layer WL may include indium-free zinc oxide. In one or more embodiments, although indium is not added to the active layer AL, the light emitting element LD which emits a color of light (e.g., green light) using a difference in band gap between zinc oxide and GaN may be fabricated. Therefore, the factors that are caused by addition of indium as described above may be substantially prevented.

In accordance with an embodiment, the light emitting element LD emits light having a wavelength. In one or more embodiments, the wavelength of light emitted from the light emitting element LD may be controlled by adjusting a ratio of oxygen and zinc in zinc oxide that forms the well layer WL. For example, the wavelength of light emitted by the light emitting element LD may be decreased as a ratio of zinc in the zinc oxide included in the well layer WL increases, and the wavelength of light emitted by the light emitting element LD may be increased as the ratio of zinc in the zinc oxide included in the well layer WL decreases.

However, embodiments are not limited thereto. For example, in order to adjust the wavelength band of light to be emitted from the light emitting element LD, zinc oxide of the well layer WL may be doped with a certain amount of indium as a dopant. For example, the band gap may be tuned or adjusted by adjusting the amounts of indium and zinc oxide.

In one or more embodiments, the light emitting element LD may further include an additional component as well as including the N-type semiconductor layer SCL1, the P-type semiconductor layer SCL2, and the active layer AL. For example, an electrode layer may be formed on one or more of opposite end portions of the light emitting element LD. In one or more embodiments, an insulating layer may be formed on an outer surface of the light emitting element LD.

For example, a light emitting element LD in accordance with a partially modified embodiment will be described. Redundant description with the above description of the embodiments will be simplified, or may be omitted for descriptive convenience.

Referring to FIG. 3, the light emitting element LD in accordance with the partially modified embodiment is different from the light emitting element LD in accordance with the embodiment of FIG. 2 in that the light emitting element LD of FIG. 3 further includes a mixed layer ML.

The active layer AL may include the mixed layer ML. For example, the mixed layer ML may be a layer formed by mixing two or more materials, and may be some layers of the active layer AL disposed adjacent to the N-type semiconductor layer SCL1 and/or the P-type semiconductor layer SCL2. In one or more embodiments, the mixed layer ML may include a first mixed layer ML1 and a second mixed layer ML2.

The first mixed layer ML1 of the active layer AL may be adjacent to the N-type semiconductor layer SCL1. For example, the first mixed layer ML1 may contact the N-type semiconductor layer SCL1. The first mixed layer ML1 may be disposed between the barrier layer BL and the N-type semiconductor layer SCL1. In one or more embodiments, a first surface of the first mixed layer ML1 may contact the N-type semiconductor layer SCL1. A second surface of the first mixed layer ML1 may contact the barrier layer BL.

The second mixed layer ML2 of the active layer AL may be adjacent to the P-type semiconductor layer SCL2. For example, the second mixed layer ML2 may contact the P-type semiconductor layer SCL2. The second mixed layer ML2 may be disposed between the barrier layer BL and the P-type semiconductor layer SCL2. In one or more embodiments, a first surface of the second mixed layer ML2 may contact the P-type semiconductor layer SCL2. A second surface of the second mixed layer ML2 may contact the barrier layer BL.

Each of the mixed layers ML may include two or more materials, and have a structure formed by mixing the two or more materials. For example, each of the mixed layers ML may include both a material for forming the N-type semiconductor layer SCL1, and a material for forming the P-type semiconductor layer SCL2, and have a structure formed by mixing the materials. Each of the mixed layers ML may include a material for forming the well layer WL, and a material for forming the barrier layer BL, and have a structure formed by mixing the materials. For example, each of the mixed layers ML may include zinc oxide and GaN, and have a structure formed by mixing the zinc oxide and GaN. For example, the lattice mismatch between the N-type semiconductor layer SCL1 and the P-type semiconductor layer SCL2 may be prevented or minimized. For example, the first mixed layer ML1 may prevent strain from occurring in the front and the rear of the position of the first mixed layer ML1. The second mixed layer ML2 may prevent strain from occurring in the front and the rear of the position of the second mixed layer ML2.

Hereinafter, a method of fabricating the light emitting element LD in accordance with an embodiment will be described.

In one or more embodiments, layers including different materials may be formed on a growth substrate GS to fabricate the light emitting elements LD. For example, a hetero-epitaxy process in which two kinds of materials are deposited on the growth substrate GS may be performed. In the case that two kinds of materials are deposited, there is a risk of occurrence of a fabrication defect due to lattice mismatch. However, as described above, the structure in accordance with an embodiment may substantially remove the risk. Hereinafter, the steps of a method of fabricating the light emitting element LD in accordance with an embodiment will be described.

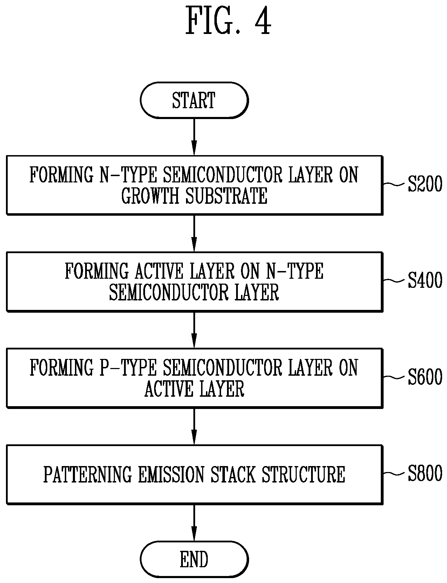

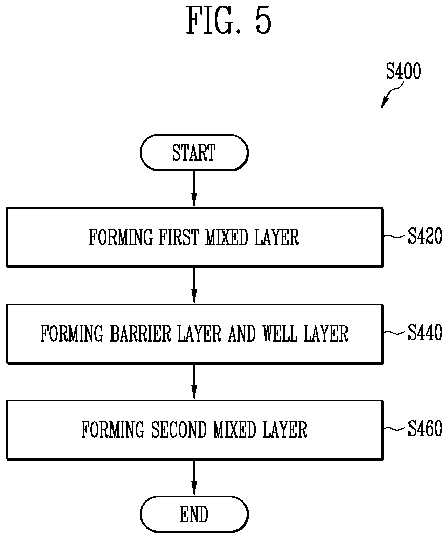

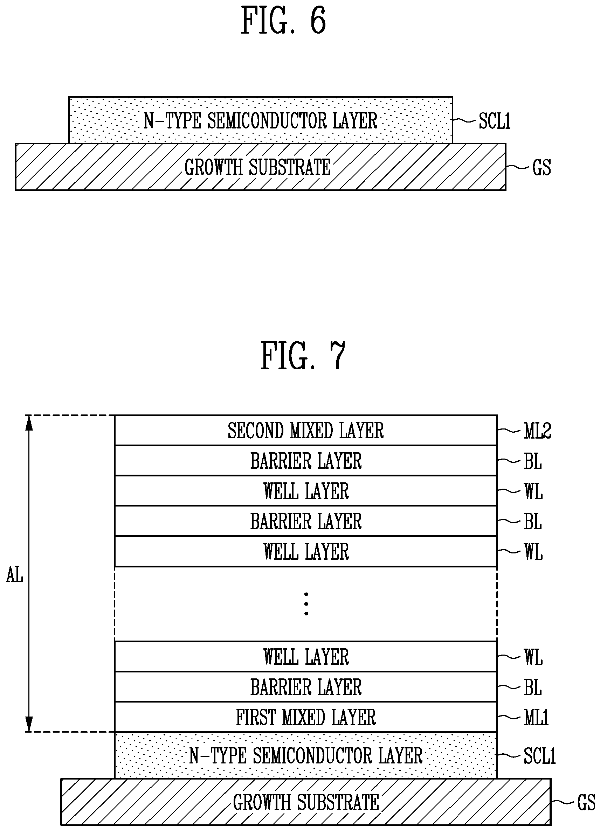

FIG. 4 is a flowchart illustrating a method of fabricating the light emitting element LD in accordance with an embodiment. FIG. 5 is a flowchart illustrating the step of forming the active layer AL in accordance with an embodiment. FIGS. 6, 7, and 8 are schematic sectional views illustrating, by process steps, a method of fabricating the light emitting element LD in accordance with an embodiment.

Referring to FIG. 4, the method of fabricating the light emitting element LD in accordance with an embodiment includes step S200 of forming the N-type semiconductor layer SCL1 on the growth substrate GS, step S400 of forming the active layer AL on the N-type semiconductor layer SCL1, step S600 of forming the P-type semiconductor layer SCL2 on the active layer AL, and step S800 of patterning an emission stack structure ES (e.g., emission stack).

Referring to FIGS. 4 and 6, in the step S200 of forming the N-type semiconductor layer SCL1 on the growth substrate GS, the N-type semiconductor layer SCL1 may be deposited (or patterned) on the growth substrate GS. In one or more embodiments, the growth substrate GS may be a base board for growing a target material. For example, the growth substrate GS may be a wafer for epitaxial growth of the target material. A material for forming the growth substrate GS is not limited to a certain example.

In the step S200, the N-type semiconductor layer SCL1 may have characteristics of an N-type semiconductor without including a separate dopant. For example, zinc oxide for forming the N-type semiconductor layer SCL1 may be fabricated under conditions of lack of oxygen or oversupply of zinc metal, so that the N-type semiconductor layer SCL1 may be fabricated to include oxygen vacancies. For example, the zinc oxide may be manufactured by using chemical vapor deposition (CVD). During the CVD process, a precursor including zinc is used, and the concentration of oxygen gas in the process environment (e.g., a deficient oxygen environment) may be controlled to produce zinc oxide including oxygen vacancies. However, embodiments are not necessarily limited thereto. Hence, the N-type semiconductor layer SCL1 may have characteristics of an N-type semiconductor as a zinc oxide semiconductor including oxygen vacancies.

Here, zinc oxide for forming the N-type semiconductor layer SCL1 may grow to form crystalline material even at low deposition temperatures. For example, as described above, zinc oxide including oxygen vacancies has wide energy band-gap, so that although the zinc oxide is exposed to visible rays, semiconductor characteristics may be prevented from being excessively degraded.

Referring to FIGS. 4 and 7, in the step S400 of forming the active layer AL on the N-type semiconductor layer SCL1, layers for providing the active layer AL may be deposited (or patterned) on the N-type semiconductor layer SCL1. For example, the barrier layer BL and the well layer WL may be alternately patterned through respective operations. For example, the respective materials of the barrier layer BL and the well layer WL may grow such that the barrier layer BL and the well layer WL may alternately stacked on each other. As described above, a GaN layer for forming the barrier layer BL may grow, and a zinc oxide layer for forming the well layer WL may be formed.

Referring to FIG. 5, the step S400 of forming the active layer AL on the N-type semiconductor layer SCL1 may include step S420 of forming a first mixed layer ML1, and step S440 of forming a barrier layer BL and a well layer WL, and step S460 of forming a second mixed layer ML2. For example, before and after the step S440 of forming the barrier layer BL and the well layer WL, the first mixed layer ML1 and the second mixed layer ML2 may be deposited (or patterned).

In one or more embodiments, in the step S420 of forming the first mixed layer ML1, the first mixed layer ML1 may be deposited (or patterned) on the N-type semiconductor layer SCL1. In one or more embodiments, in the step S420, the first mixed layer ML1 may contact the N-type semiconductor layer SCL1. In one or more embodiments, to form a structure in which zinc oxide and GaN are mixed with each other, a ratio of oxygen and zinc in the zinc oxide to be supplied (or provided) may be adjusted when patterning the first mixed layer ML1. For example, with regard to a composition ratio of zinc oxide to be supplied, oxygen may be contained at a content lower than that of zinc, and GaN may be supplied to the zinc oxide so that the zinc oxide and GaN may be mixed with each other. Hence, the first mixed layer ML1 in which zinc oxide and GaN are mixed with each other may be patterned adjacent (e.g., directly adjacent) to the top of the N-type semiconductor layer SCL1.

In one or more embodiments, in the step S460 of forming the second mixed layer ML2, the second mixed layer ML2 may be deposited (or patterned) on the barrier layer BL. In one or more embodiments, in order to form a structure in which zinc oxide and GaN are mixed with each other, a ratio of oxygen and zinc in the zinc oxide to be supplied may be adjusted when patterning the second mixed layer ML2. For example, with regard to a composition ratio of zinc oxide to be supplied, oxygen may be contained at a content lower than that of zinc, and GaN may be supplied to the zinc oxide so that the zinc oxide and GaN may be mixed with each other. Hence, the second mixed layer ML2 in which zinc oxide and GaN are mixed with each other may be patterned adjacent (e.g., directly adjacent) to the top of the barrier layer BL.

Accordingly, the active layer AL in accordance with an embodiment may have a structure in which the well layer WL and the barrier layer BL are alternately disposed between the first mixed layer ML1 and the second mixed layer ML2, and strain may be prevented from occurring in the light emitting element LD.

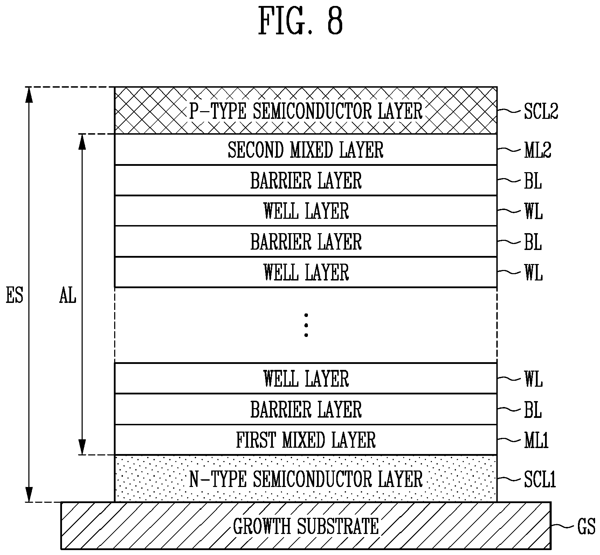

Referring to FIGS. 4 and 8, in the step S600 of forming the P-type semiconductor layer SCL2 on the active layer AL, the P-type semiconductor layer SCL2 may be deposited (or patterned) on the active layer AL. Hence, the emission stack structure ES in which the N-type semiconductor layer SCL1, the active layer AL, and the P-type semiconductor layer SCL2 are successively stacked may be formed.

In the step S600, a dopant may be provided so that the P-type semiconductor layer SCL2 having characteristics of a P-type semiconductor may be formed. For example, a GaN layer doped with Mg may be patterned on the active layer AL.

In the case that an oxide semiconductor is formed after a nitride oxide is formed, there is a risk of oxidation of materials (e.g., GaN) for forming the nitride semiconductor or permeation of impurities, under conditions of a process of forming an oxide semiconductor. In the case that a zinc oxide semiconductor layer is patterned after a P-type GaN layer is patterned, a process may be performed under high-concentration oxygen atmosphere to pattern the zinc oxide semiconductor layer. Hence, there is the probability of oxidation of the P-type GaN layer. However, in one or more embodiments, the P-type semiconductor layer SCL2 including a nitride semiconductor (e.g., GaN) may be formed after formation of the N-type semiconductor layer SCL1 including an oxide semiconductor (e.g., a zinc oxide semiconductor), so that the oxidation of the P-type semiconductor layer SCL2 including a nitride semiconductor (e.g., GaN) may be removed or prevented.

Referring to FIGS. 4 and 8, in the step S800 of patterning the emission stack structure ES, the emission stack structure ES including layers may be patterned and provided as individual light emitting elements LD.

In the step S800, the emission stack structure ES may be divided at regular intervals. Thus, light emitting elements LD each having a constant size may be formed. The light emitting elements LD that are individually separated from each other each may function as a self-emissive element through a process.

Hereinafter, a display device DD including light emitting elements LD in accordance with an embodiment will be described.

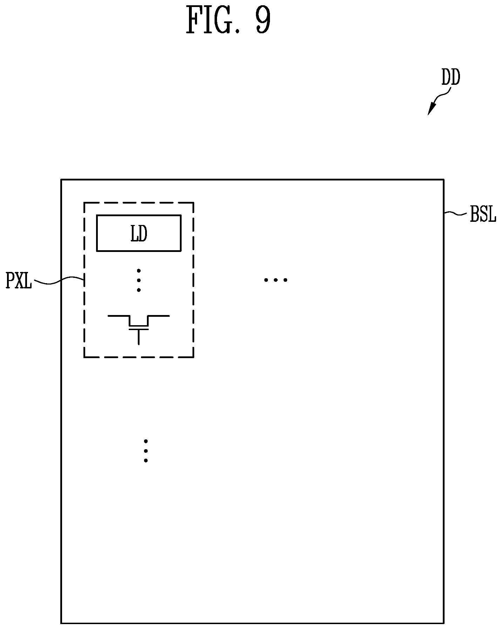

FIG. 9 is a schematic plan view illustrating the display device DD in accordance with an embodiment. Referring to FIG. 9, the display device DD in accordance with an embodiment includes a base layer BSL, and pixels PXL formed on the base layer BSL.

In one or more embodiments, the base layer BSL may be a component for forming a base surface on which the pixel PXL is disposed, and may be a substrate or a film. In one or more embodiments, the base layer BSL may be a rigid substrate made of glass. In another example, the base layer BSL may be a flexible substrate which is bent, folded, or rolled. For example, the base layer BSL may include insulating material such as polymer resin, e.g., polyimide.

In one or more embodiments, the pixels PXL may include the above-described light emitting elements LD and driving circuits for driving the light emitting elements LD. For example, the light emitting elements LD may emit light based on an electrical signal supplied from driving transistors of the driving circuits. In one or more embodiments, the light emitting elements LD may respectively emit various colors of light. Light emitting elements LD that emit a same color of light may respectively form sub-pixels. The formed sub-pixels may form one or more pixels PXL (or pixel units).

Various embodiments may provide a light emitting element, a method of fabricating the light emitting element, and a display device including the light emitting element, which has improved emission efficiency and is able to prevent various factors from occurring during a fabrication process.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

## Claims

1. A light emitting element comprising:
an N-type semiconductor layer including a zinc oxide semiconductor;
a P-type semiconductor layer; and
an active layer disposed between the N-type semiconductor layer and the P-type semiconductor layer,
wherein the active layer has a quantum well including a barrier layer and a well layer including zinc oxide.

2. The light emitting element according to claim 1, wherein the zinc oxide semiconductor of the N-type semiconductor layer includes an oxygen vacancy and is not doped with a dopant.

3. The light emitting element according to claim 2, wherein
the P-type semiconductor layer includes GaN having P-type semiconductor characteristics, and
the well layer includes GaN.

4. The light emitting element according to any one of claims 1 to 3, wherein
the N-type semiconductor layer and the well layer include a same material, and
the P-type semiconductor layer and the barrier layer include a same material.

5. The light emitting element according to any one of claims 1 to 4, wherein the well layer includes indium-free zinc oxide.

6. The light emitting element according to any one of claims 1 to 5, wherein the active layer further includes a mixed layer formed by mixing two or more materials with each other.

7. The light emitting element according to claim 6, wherein the mixed layer comprises:
a first mixed layer adjacent to the N-type semiconductor layer; and
a second mixed layer adjacent to the P-type semiconductor layer.

8. The light emitting element according to claim 7, wherein
the well layer and the barrier layer are disposed between the first mixed layer and the second mixed layer,
the first mixed layer contacts the N-type semiconductor layer, and
the second mixed layer contacts the P-type semiconductor layer.

9. The light emitting element according to claim 7 or claim 8, wherein:
(i) each of the first mixed layer and the second mixed layer is formed by mixing a material for forming the N-type semiconductor layer and a material for forming the P-type semiconductor layer; or
(ii) each of the first mixed layer and the second mixed layer is formed by mixing a material for forming the well layer and a material for forming the barrier layer; and/or
(iii) each of the first mixed layer and the second mixed layer includes zinc oxide and GaN.

10. A light emitting element according to claim 1, wherein:
the P-type semiconductor layer includes GaN; and
the barrier layer includes a material of the P-type semiconductor layer.

11. A method of fabricating a light emitting element, the method comprising:
forming an N-type semiconductor layer on a growth substrate;
forming an active layer on the N-type semiconductor layer;
forming a P-type semiconductor layer on the active layer; and
patterning an emission stack including the N-type semiconductor layer, the active layer, and the P-type semiconductor layer, wherein
the N-type semiconductor layer includes an oxide material,
the P-type semiconductor layer includes a nitride material, and
the active layer has a quantum well including a barrier layer and a well layer including zinc oxide.

12. The method according to claim 11, wherein:
(i) the N-type semiconductor layer is formed before the forming of the P-type semiconductor layer; and/or
(ii) the forming of the N-type semiconductor layer comprises forming the N-type semiconductor layer such that a zinc oxide semiconductor layer includes an oxygen vacancy; and/or
(iii) the N-type semiconductor layer includes a zinc oxide semiconductor layer including an oxygen vacancy,
the well layer includes GaN, and
the P-type semiconductor layer includes GaN doped with a dopant.

13. The method according to claims 11 or claim 12, wherein the forming of the active layer comprises:
forming a first mixed layer on the N-type semiconductor layer;
forming the barrier layer and the well layer on the first mixed layer; and
forming a second mixed layer on the barrier layer and the well layer.

14. The method according to claim 13, wherein:
(i) the forming of the first mixed layer comprises:
providing zinc oxide having a composition ratio at which a content of oxygen is lower than a content of zinc; and
providing GaN; and/or
(ii) the forming of the first mixed layer comprises disposing the first mixed layer into contact with the N-type semiconductor layer.

15. A display device comprising:
a base layer; and
a pixel disposed on the base layer and including a light emitting element, wherein
the light emitting element comprises:
an N-type semiconductor layer;
a P-type semiconductor layer; and
an active layer disposed between the N-type semiconductor layer and the P-type semiconductor layer, and
the active layer has a quantum well including a barrier layer and a well layer including zinc oxide.
